(19) Europäisches Patentamt

European Patent Office

Office européen des brevets

(11) Veröffentlichungsnummer: **0 262 450 B1**

(12) **EUROPÄISCHE PATENTSCHRIFT**

(45) Veröffentlichungstag der Patentschrift: **11.03.92**

(21) Anmeldenummer: **87112930.0**

(22) Anmeldetag: **04.09.87**

(51) Int. Cl.⁵: **H05K 7/18**, H05K 7/14

(54) **Mehrzweck-Tischgehäuse.**

(30) Priorität: **30.09.86 DE 3633284**

(43) Veröffentlichungstag der Anmeldung:
**06.04.88 Patentblatt 88/14**

(45) Bekanntmachung des Hinweises auf die
Patenterteilung:
**11.03.92 Patentblatt 92/11**

(84) Benannte Vertragsstaaten:
**AT BE CH DE ES FR GB GR IT LI LU NL SE**

(56) Entgegenhaltungen:
**DE-A- 2 731 328**
**DE-A- 3 334 587**
**FR-A- 2 312 917**
**FR-A- 2 374 819**
**FR-A- 2 460 091**

(73) Patentinhaber: **Rittal-Werk Rudolf Loh GmbH & Co. KG**
**Auf dem Stützelberg**
**W-6348 Herborn(DE)**

(72) Erfinder: **Berg, Franco**
**Am Walde 2**
**W-3304 Isernhagen(DE)**
Erfinder: **Bovermann, Claus-Dieter**
**Am Oberg 7**
**W-3565 Breidenbach-Niederdieten(DE)**

(74) Vertreter: **Vogel, Georg**
**Pat.-Ing. Georg Vogel Hermann-Essig-Strasse 35**
**W-7141 Schwieberdingen(DE)**

# Beschreibung

Die Erfindung betrifft ein Mehrzweck-Tischgehäuse für elektrotechnische Einrichtungen, das aus zwei gleichen Seitenteilen, einem Oberteil und einem Unterteil zusammengesetzt und mit Vorrichtungen zum Einbau von Baugruppenträgern, Leiterplatten-Tragleisten und Einschub-Gleitschienen sowie zum Anbringen einer Rückwand, einer Tür oder eines Sichtfensters versehen ist.

Ein Mehrzweck-Tischgehäuse dieser Art ist aus der DE-OS 33 34 587 bekannt. Unter Verzicht auf einen Rahmen oder Gerüst werden die Teile des Mehrzweck-Tischgehäuses durch entsprechende Ausgestaltung direkt miteinander verbunden. Dabei wird zudem darauf geachtet, daß möglichst viele gleiche Teile verwendet werden können. Dieses bekannte Mehrzweck-Tischgehäuse erleichtert den Zusammenbau. Für den Einbau von Baugruppenträgern, Leiterplatten-Tragleisten und Einschub-Gleitschienen sind jeweils besondere Vorrichtungen erforderlich und in das Mehrzweck-Tischgehäuse einzubauen.

Wie die DE-AS 25 23 292 zeigt, sind bei derartigen Mehrzweck-Tischgehäusen auch schon Abschnitte von Profilsträngen als Ober- und Unterteil verwendet worden. Die Innenseiten dieser Abschnitte tragen in regelmäßigen Abständen T-Nuten, in die Muttern eingesetzt und längsverschiebbar geführt sind. Auf diese Weise lassen sich zusätzliche Befestigungsteile mit dem Ober- und dem Unterteil verbinden. Dieser Aufbau eines Mehrzweck-Tischgehäuses ist bei einer Höhe zum Einbau eines einzigen Baugruppenträgers oder einer einzigen Reihe von Leiterplatten geeignet. Bei größeren Höhen des Mehrzweck-Tischgehäuses treten Befestigungsprobleme auf, da die glatten Seitenteile keine dafür erforderlichen Befestigungsmöglichkeiten bieten.

Es ist Aufgabe der Erfindung, ein Mehrzweck-Tischgehäuse der eingangs erwähnten Art zu schaffen, bei dem unter Beibehaltung einfacher, einheitlicher Teile der Einbau von Baugruppenträgern, Leiterplatten-Tragschienen und Einschub-Gleitschienen sowie das Anbringen der Rückwand und einer Tür oder eines Sichtfensters in beliebigen Höhen des Aufnahmeraumes des Mehrzweck-Tischgehäuses möglich ist, der auch auf einfache Weise in seiner Höhe an den Bedarf der einzubauenden Einrichtungen angepaßt werden kann.

Diese Aufgabe wird nach der Erfindung dadurch gelöst, daß die Seitenteile auf ihren Innenseiten in gleichen Abständen zueinander angeordnete und vertikal durchgehend verlaufende T-Nuten aufweisen, daß zumindest bei einem Teil der T-Nuten der Nutgrund offen ist und in einen im Querschnitt etwa runden, durchgehenden Schraubkanal übergeht, daß die ersten und letzten T-Nuten der Seitenteile in Eckteilen angeordnet und von der zugeordneten Innenseite in Richtung zu der Außenseite hin um ein vorgegebenes Maß versetzt sind und daß in die T-Nuten Verbindungsleisten mit Gewindebohrungen oder Abdeckleisten einschiebbar sind.

Die Verlagerung der T-Nuten in die Seitenteile bringt den Vorteil gegenüber den bekannten Mehrzweck-Tischgehäusen, daß mehrere Einbaufelder übereinander geschaffen werden können, wobei in allen Einbaufeldern Freizügigkeit besteht, einen Baugruppenträger, Leiterplatten-Tragschienen oder Einschub-Gleitschienen einzusetzen. Durch den Versatz der T-Nuten in den Eckteilen, werden an den offenen Seiten des aus den Seitenteilen, dem Ober- und dem Unterteil zusammengesetzten Rahmen die Aufnahmen für die Anbringung einer Rückwand, einer Tür oder eines Sichtfensters gebildet und sofort die Befestigungsmöglichkeiten für diese geschaffen. Das Mehrzweck-Tischgehäuse wird dadurch universell verwendbar und bei komplettem Ausbau mit Rückwand und Tür oder Sichtfenster zu einer optisch und ästhetisch ansprechenden Einheit. Die Seitenteile können als Abschnitte von Profilsträngen ausgebildet und so in einfacher Weise an unterschiedliche Bauhöhen für das Gehäuse angepaßt werden.

Die Schraubkanäle können an den horizontalen Rändern der Seitenteile direkt die Befestigungsschrauben für das Ober-und Unterteil aufnehmen. Dabei werden selbstschneidende Befestigungsschrauben bei Metall-Seitenteilen, z.B. aus Aluminium, bevorzugt.

Die Ausgestaltung der Seitenteile ist nach einer Ausführung so vorgenommen, daß jedes Seitenteil aus einem Abschnitt eines plattenförmigen Profilstranges mit T-Nuten und zwei Eckteilen zusammengesetzt ist, daß die Eckteile als Abschnitte eines Eckprofilstranges ausgebildet und im Bereich der vertikalen Ränder auf der Außenseite des Abschnittes befestigt sind, und daß die Eckteile über die vertikalen Ränder des Abschnittes vorstehen und in den vorstehenden Bereichen der parallel zur Innenseite des Abschnittes verlaufenden Seiten die zur Außenseite hin versetzten T-Nuten tragen. Der Eckprofilstrang wird dabei vorzugsweise als Kastenhohlprofil ausgebildet.

Die Verbindung des Abschnittes mit den beiden Eckteilen ist nach einer Ausgestaltung so gelöst, daß auf der Außenseite der Abschnitte im Bereich jedes vertikalen Randes jeweils mindestens eine Verbindungsnut eingebracht ist, daß die Eckteile auf der dem Abschnitt zugekehrten Seite mit Verbindungsstegen versehen sind, die in zugeordnete Verbindungsnuten des Abschnittes eingeführt sind, und daß im Bereich einander zugekehrter, senkrecht zum Abschnitt stehender Seiten von Verbindungsnut und Verbindungssteg ein durchgehender, im Querschnitt runder und vertikal durchgehend verlaufender Verbindungskanal für einen Verbindungsbolzen ausgespart ist.

Ist vorgesehen, daß die Eckteile mit einem Abschlußsteg den zugekehrten vertikalen Rand des Abschnittes abdecken, dann wird an den vertikalen Seiten der Aufnahmen für die Rückwand, die Tür oder das Sichtfenster ein geschlossener Übergang erreicht.

Der Teileaufwand läßt sich dabei noch dadurch reduzieren, daß der Abschnitt und die beiden Eckteile eines Stirnteils als einstückiger Abschnitt eines Seitenwand-Profilstranges zusammengefaßt sind.

Die Ausgestaltung ist weiterhin sor vorgesehen, daß alle T-Nuten gleichen Querschnitt aufweisen, wobei der hinterschnittene Bereich über zur Innenseite hin geneigte Übergangsabschnitte in den Einführungsschlitz der T-Nuten übergeht, damit einheitliche Querschnitte für die Verbindungsleisten und die Abdeckleisten verwendet werden können.

Der Zusammenbau des Mehrzweck-Tischgehäuses wird dadurch noch vereinfacht, daß das Oberteil und das Unterteil identisch ausgebildet und im Bereich der vertikalen Ränder der Seitenteile mit einem als Anschlag dienenden Absatz versehen sind, da die Anschläge die Stellung der Seitenteile vorgeben.

Ist nach einer weiteren Ausgestaltung vorgesehen, der Durchmesser der Gewindebohrungen in den Verbindungsleisten größer ist als die Breite der Öffnung im Nutgrund der T-Nuten, dann läßt sich eine Verbindungsleiste mittels einer in eine Gewindebohrung eingeschraubten Madenschraube oder dgl. in der T-Nut verspannen, da sich die Madenschraube oder dgl. an dem Nutgrund der T-Nut trotz Öffnung zum Schraubkanal abstützen kann.

Eine Vielzahl von Befestigungsstellen oder eine volle Abdeckung einer T-Nut über die gesamte Höhe des Mehrzweck-Tischgehäuses erreicht man am einfachsten dadurch, daß die Länge der Verbindungsleisten und der Abdeckleisten der Höhe des Abschnittes und der Eckteile der Seitenteile entspricht.

Zum Einbau eines mit seitlichen Befestigungsflanschen versehenen Baugruppenträgers sind Befestigungswinkel vorgesehen, die jeweils mit einem Schenkel über eine Verbindungsleiste mit den Seitenteilen verschraubt sind, und daß die Befestigungsflansche des Baugruppenträgers mit den gegeneinander gerichteten Schenkeln der Befestigungswinkel lösbar verbunden sind. Die Befestigungsflansche des Baugruppenträgers sind lösbar mit den gegeneinander gerichteten Schenkeln der Befestigungswinkel verbunden.

Leiterplatten-Tragschienen sind über U-förmige Befestigungsteile und Verbindungsleisten mit den Seitenteilen verbunden.

In beiden Fällen ist eine Einschraubbefestigung möglich, wenn vorgesehen ist, daß die Befestigungswinkel und die Befestigungsteile mit zusätzlichen Fixierstegen versehen sind, die in T-Nuten eingeführt den Befestigungswinkel und das Befestigungsteil bei einer Befestigung mittels einer einzigen Schraube unverdrehbar am Seitenteil festhalten.

Für die Anbringung einer Rückwand am Mehrzweck-Tischgehäuse ist nach einer Ausgestaltung vorgesehen, daß eine boxartige Rückwand mittels Vorreiber, die an der Rückwand drehbar gelagert sind, durch einen Durchbruch im vertikalen Rand der Rückwand herausragen und in die nach außen versetzten T-Nuten der Eckteile einschwenkbar sind, an den Seitenteilen gehalten ist.

Die Anlenkung einer Tür oder eines Sichtfensters an dem Mehrzweck-Tischgehäuse ist nach einer Ausgestaltung so gelöst, daß eine Tür oder ein Sichtfenster im Bereich einer vertikalen Kante mit verschwenkbaren Scharnierteilen von Scharnieren fest verbunden ist und daß die damit gelenkig verbundenen feststehenden Scharnierteile mittels Verbindungsleisten und Schrauben in den nach außen versetzten T-Nuten der Eckteile festgelegt sind. Dabei kann die Befestigung dadurch vereinfacht werden, daß an den feststehenden Scharnierteilen Verbindungsleisten mit Gewindebohrungen angeformt sind.

Einschub-Gleitschienen werden dadurch eingebaut, daß die L-förmig ausgebildeten Einschub-Gleitschienen mit einem Schenkel mittels Verbindungsleisten jeweils in mindestens zwei T-Nuten eines Seitenteils horizontal gerichtet an den Seitenteilen befestigt sind.

Die Erfindung wird anhand eines in den Zeichnungen dargestellten Ausführungsbeispiels näher erläutert. Es zeigt jeweils im Teilschnitt,

Fig. 1 die Ausgestaltung eines Seitenteils,

Fig. 2 den Einbau eines Baugruppenträgers,

Fig. 3 den Einbau einer Leiterplatten-Tragschiene,

Fig. 4 die Anbringung einer Rückwand,

Fig. 5 die Anlenkung eines Sichtfensters und

Fig. 6 den Einbau einer Einschub-Gleitschiene.

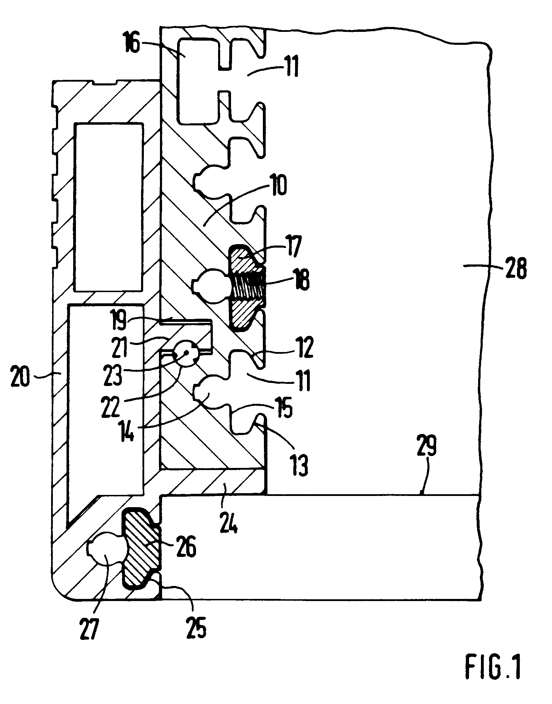

Die Fig. 1 zeigt den vorderen Teil des Abschnittes 10 eines Seitenteils, das auf dem plattenförmigen Unterteil 28 befestigt ist. Die Innenseite des Abschnittes 10, der von einem plattenförmigen Profilstrang in der der Höhe des gewünschten Innenraumes des Mehrzweck-Tischgehäuses abgelängt ist, ist mit in gleichmäßigem Abstand T zueinander angeordneten T-Nuten 11 versehen. Der breitere Bereich dieser vertikal durchgehend verlaufenden T-Nuten 11 geht über die geneigten Übergangsabschnitte 12 und 13 in den Einführungsschlitz der T-Nuten 11 über. Der Nutboden 15 hat eine Öffnung, die in einen im Querschnitt runden Schraubkanal 14 überleitet. An den horizontalen Rändern des Abschnittes 10 können daher selbstschneidende Befestigungsschrauben in einen Schraubkanal 14 eingeschraubt werden und so das Unterteil 28 und das identisch ausgebildete Oberteil mit den Seitenteilen verschraubt werden. Die Seitenteile bestehen dabei vorzugsweise aus Metall, z.B. Aluminium, während das Ober- und Unterteil 28 als Spritzgußteil aus Metall oder Kunststoff hergestellt sein kann. Ein Teil der T-Nuten 11 kann im Nutboden 15 auch eine Öffnung zu einem im Querschnitt rechteckförmigen durchgehenden Aufnahmekanal 16 aufweisen, der z.B. für die Führung von Verbindungskabeln ausgenützt werden kann.

Der Abschnitt 10 bildet mit zwei gleichen Eckteilen 20 eine Seitenwand. Die Eckteile 20 werden in gleicher Länge von einem Eckprofilstrang abgelängt. Es handelt sich dabei um ein Kastenhohlprofil, an dem ein Abschlußsteg 24 angeformt ist. Im Bereich der beiden vertikalen Ränder des Abschnittes 10 ist auf der Außenseite mindestens eine Verbindungsnut 19 eingebracht, in die ein an dem Eckteil 20 angeformter Verbindungssteg 21 eingeführt ist.

An einander zugekehrten und senkrecht zum Abschnitt 10 stehenden Seiten von Verbindungsnut 19 und Verbindungssteg 21 sind halbkreisförmige Aussparungen eingebracht, die sich zu einem im Querschnitt runden und durchgehend verlaufenden Verbindungskanal 22 für den Verbindungsbolzen 23 ergänzen. Auf diese Weise lassen sich die Eckteile 20 leicht mit dem Abschnitt 10 verbinden, wobei der Abschlußsteg 24 die vertikale Stirnseite des Abschnittes 10 abdeckt und die Teilung, d.h. den Abstand T, zur benachbarten T-Nut 11 des Abschnittes 10 vervollständigt. Die Eckteile 20 stehen über die vertikalen Ränder des Abschnittes 10 vor und tragen in der parallel zur Innenseite des Abschnittes 10 verlaufenden Seite eine T-Nut 25, die gegenüber den T-Nuten 11 des Abschnittes 10 um die Dicke des Abschnittes 10 nach außen versetzt sind. Auf diese Weise begrenzen die Eckteile 20 an den offenen Seiten des aus zwei Seitenteilen, dem Oberteil und dem Unterteil 28 zusammengesetzten Rahmens Aufnahmen zum Einsetzen einer Rückwand, einer Tür oder eines Sichtfensters, wie noch gezeigt wird. Dabei weisen Ober-und Unterteil 28 Absätze 29 auf, die den Zusammenbau des Mehrzweck-Tischgehäuses erleichtern.

Werden die versetzten T-Nuten 25 nicht benötigt, dann werden Abschlußleisten 26 eingeschoben. Auch diese versetzten T-Nuten 25 sind mit einem durchgehenden Schraubkanal 27 versehen und sind im Querschnitt identisch mit den T-Nuten 11 des Abschnittes 10. In die T-Nuten 11 können Verbindungsleisten 17 eingeschoben werden, die mit einer Reihe von in einer vorgegebenen Teilung eingebrachten Gewindebohrungen 18 versehen sind. Diese Abschlußleisten 26 und Verbindungsleisten 17 können auf die Höhe der Seitenteile ausgelegt sein. Es können auch kurze Verbindungsleisten 17 an beliebigen Stellen der T-Nut 11 festgelegt werden. Dazu hat die Gewindebohrung 18 einen Durchmesser, der größer ist als die Breite der Öffnung im Nutgrund 15. Eine eingeschraubte Madenschraube kann sich daher immer noch am Nutgrund 15 abstützen und so die Verbindungsleiste 17 in der T-Nut 17 verspannen. Da die Seitenteile an beiden vertikalen Randbereichen gleich ausgebildet sind, ergeben sich an beiden offenen Seiten gleiche Aufnahmen und der Innenraum ist über seine gesamte Tiefe mit Verbindungsleisten 17 versehbar, so daß bei entsprechender Tiefe auch ein beidseitig bestückbares und zugängliches Mehrzweck-Tischgehäuse gebaut werden kann, das mittels zweier Türen oder Sichtfenster verschließbar ist. Auch in der Höhe des Innenraumes ist das Mehrzweck-Tischgehäuse leicht anpaßbar, da nur die Abschnitte 10 und die Eckteile 20 in den erforderlichen Längen abgelängt werden müssen. Der Abschnitt 10 mit den beiden Eckteilen 20 kann aber auch als einstückiger Abschnitt eines entsprechenden Profilstranges ausgebildet sein, wodurch sich der Teileaufwand entsprechend verringert. Der Einsatz von zusammengesetzten Seitenteilen empfiehlt sich dann, wenn die Abschnitte 10 für unterschiedlich tiefe Mehrzweck-Tischgehäuse in verschiedenen Breiten zur Verfügung gestellt werden.

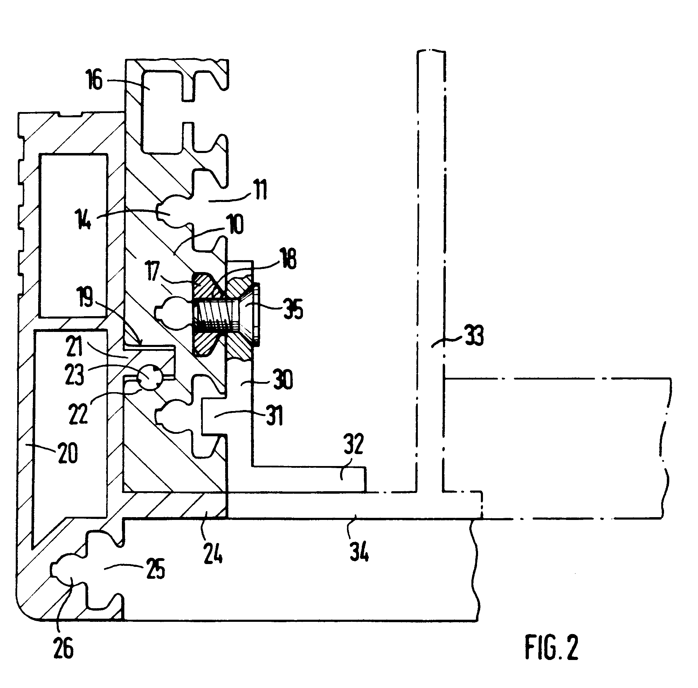

Fig. 2 zeigt, wie ein mit Befestigungsflanschen 34 versehener Baugruppenträger 33 mit Hilfe von zwei Befestigungswinkeln 30 eingebaut wird. Jeweils ein Schenkel der Befestigungswinkel 30 ist mit Schrauben 35 über die in eine T-Nut 11 eingeschobene Verbindungsleiste 17 mit dem zugekehrten Seitenteil verbunden. Die anderen Schenkel 32 der Befestigungswinkel 30 sind gegeneinander gerichtet und die Befestigungsflansche 34 des Baugruppenträgers 33 werden lösbar mit diesen Schenkeln 32 der Befestigungswinkel 30 verbunden, z.B. verschraubt. Dabei sind die Befestigungswinkel 30 so bemessen, daß die angebrachten Befestigungsflansche 34 des Baugruppenträgers 33 bündig mit den Abschlußstegen 24 der Eckteile 20 der Seitenteile abschließen, so daß die Aufnahme für die Tür oder das Sichtfenster nicht beeinträchtigt wird. Die Befestigung eines Befestigungswinkels 30 kann mit einer einzigen Schraube 35 erfolgen, wenn der am Befestigungswinkel 30 angeformte Fixiersteg 31 in eine freie T-Nut 11 eingeführt wird und den Befestigungswinkel 30 unverdrehbar festhält.

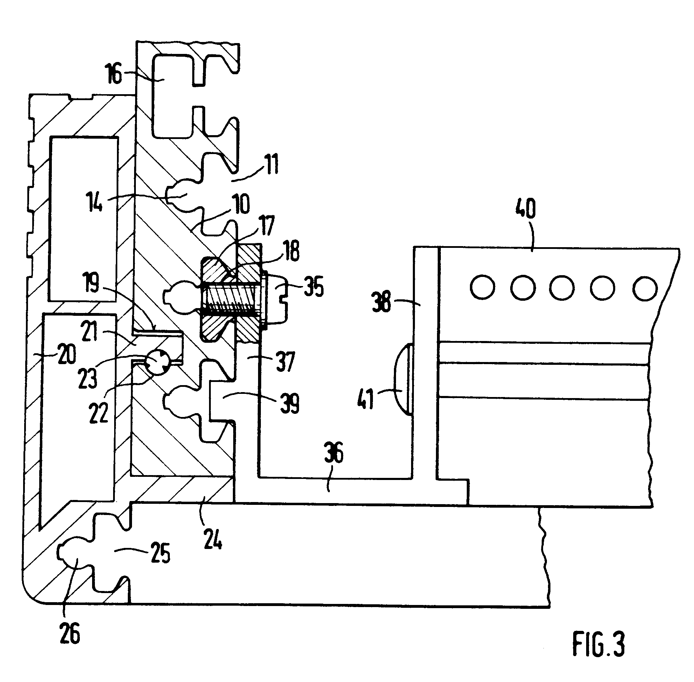

Wie die Fig. 3 zeigt, kann eine Leiterplatten-Tragleiste 40 über zwei U-förmige Befestigungsteile 36 mit den Seitenteilen des Mehrzweck-Tischgehäuses verbunden werden. Die Schraube 35 legt den Schenkel 37 des Befestigungsteiles 36 an dem Abschnitt 10 fest. Der Fixiersteg 39 bringt die unverdrehbare Festlegung des Befestigungsteiles 36 und die Schraube 41 verbinden den Schenkel 37 des Befestigungsteiles 36 mit der Leiterplatten-Tragleiste 40. Auch hier schließt das Befestigungsteil 36 bündig mit dem Abschlußsteg 24 des Eckteils 20 ab.

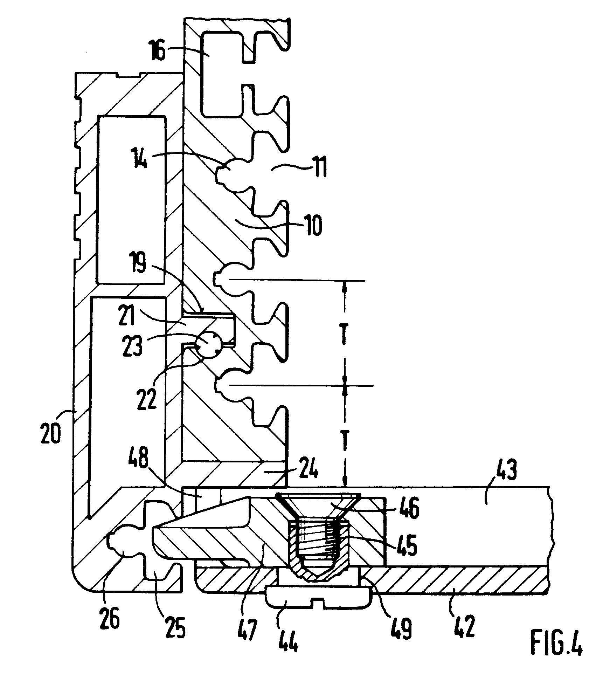

Die mit dem umlaufenden Rand 43 versehene Rückwand 42 wird, wie Fig. 4 zeigt, mit Vorreibern 47 an dem Mehrzweck-Tischgehäuse festgelegt. In Bohrungen 49 der Rückwand 42 sind Lagerschrauben 44 drehbar gelagert. Die Schraube 46 verbindet den Vorreiber 47 mit der Lagerschraube 44, die mit einer entsprechenden Gewindeaufnahme 45 versehen ist. Der vertikale Rand weist Durchbrüche 48 auf, durch die die Vorreiber 47 aus der Rückwand 42 ragen und in die versetzten T-Nuten 25 der Eckteile 20 der Seitenteile eingeschwenkt werden können. Die Rückwand 42 läßt sich so z.B. mit vier Vorreibern 47 leicht lösbar an dem Mehrzweck-Tischgehäuse anbringen, wobei sie die Aufnahme an der offenen Seite des Mehrzweck-Tischgehäuses bündig abschließt. Die Lagerschrauben 44 sind mit einem Schlitz versehen, so daß sie von außen mit dem daran drehfest angebrachtn Vorreiber 47 verdreht werden können.

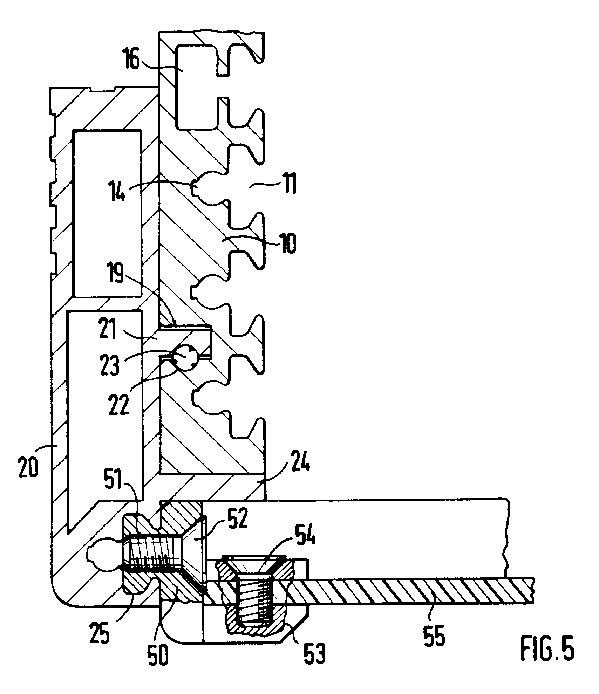

Die Fig. 5 zeigt die Anlenkung eines Sichtfensters 55 in einer Aufnahme. Die beweglichen Scharnierteile 53 sind mit den Schrauben 54 fest mit dem Sichtfenster 55 verbunden. Die gelenkig angebrachten, feststehenden Scharnierteile 50 der Scharniere werden in den versetzten T-Nuten 25 der Eckteile 20 der Seitenteile festgelegt. Dabei sind diese Scharnierteile 50 selbst mit einer Verbindungsleiste versehen, so daß die Schraube 52 in die Gewindebohrung 51 eingeschraubt und darüber das Scharnierteil 50 in der versetzten T-Nut 25 verspannt werden kann. Das Sichtfenster 55 verschließt die offene Seite des Mehrzweck-Tischgehäuses bündig. Auf der anderen Seite des Sichtfensters 55 werden die Teile eines Verschlusses in derselben Weise mit dem Sichtfenster 55 und dem zugekehrten Eckteil 20 des Seitenteils verbunden. Lediglich im Bereich der Scharniere und des Verschlusses stehen Teilbereiche geringfügig am Mehrzweck-Tischgehäuse ab. Die Außenseite des Abschlußsteges 24 steht im Abstand T zur Mitte der benachbarten T-Nut 11 des Abschnittes 10, so daß die versetzte T-Nut 25 in einem Abstand gewählt werden kann, der auf die Dicke der Rückwand 42 der Fig. 4 oder der Tür nach Fig. 5 angepaßt wird.

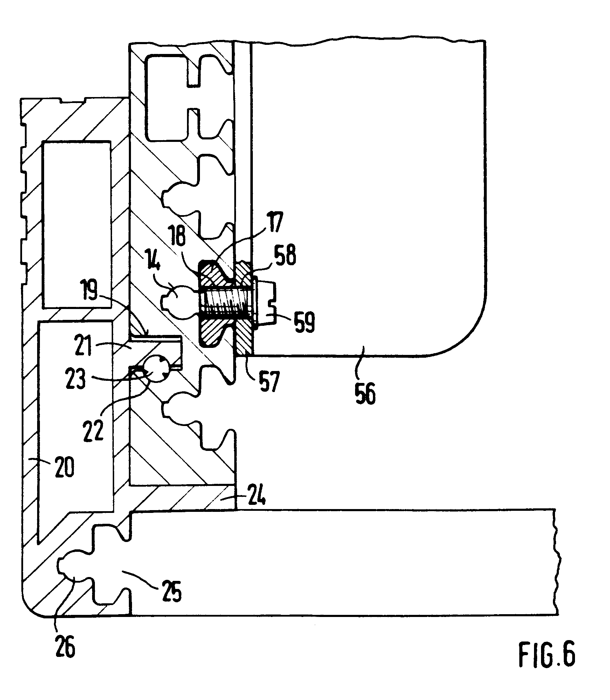

Schließlich wird, wie Fig. 6 zeigt, eine im Querschnitt L-förmige Einschub-Gleitschiene 56 mit dem vertikalen Schenkel 57 an dem Abschnitt 10 verschraubt. Die Schraube 59 wird durch die Bohrung 58 hindurch in die Gewindebohrung 58 der Verbindungsleiste 17 eingeschraubt. Erstreckt sich die Verbindungsleiste 17 nicht über die ganze Höhe des Abschnittes 10, dann kann sie beliebig verstellt und mit einer Schraube, die in eine nicht belegte Gewindebohrung 18 eingeschraubt wird, in der T-Nut 11 verspannt und festgelegt werden. Jede Einschub-Gleitschiene 56 wird so an mindestens zwei Stellen in der horizontalen Stellung an dem Seitenteil befestigt. Der Einschub stützt sich auf den horizontalen Schenkeln der Einschub-Gleitschienen 56 ab. In gleicher Weise lassen sich auch Einschübe über Teleskopauszüge an den Seitenwänden des Mehrzweck-Tischgehäuses befestigen.

**Patentansprüche**

1. Mehrzweck-Tischgehäuse für elektrotechnische Einrichtungen, das aus zwei gleichen Seitenteilen, einem Oberteil und einem Unterteil zusammengesetzt und mit Vorrichtungen zum Einbau von Baugruppenträgern, Leiterplatten-Tragleisten und Einschub-Gleitschienen sowie zum Anbringen einer Rückwand, einer Tür oder eines Sichtfensters versehen ist,

   dadurch gekennzeichnet,

   daß die Seitenteile auf ihren Innenseiten in gleichen Abständen (T) zueinander angeordnete und vertikal durchgehend verlaufende T-Nuten (11) aufweisen,

   daß zumindest bei einem Teil der T-Nuten (11) der Nutgrund (15) offen ist und in einen im Querschnitt etwa runden, durchgehenden Schraubkanal (14) übergeht,

   daß die ersten und letzten T-Nuten (25) der Seitenteile in Eckteilen (20) angeordnet und von der zugeordneten Innenseite in Richtung zu der Außenseite hin um ein vorgegebenes Maß versetzt sind und

   daß in die T-Nuten (11,25) Verbindungsleisten (17) mit Gewindebohrungen (18) oder Abdeckleisten (26) einschiebbar sind.

2. Mehrzweck-Tischgehäuse nach Anspruch 1, dadurch gekennzeichnet,

   daß jedes Seitenteil aus einem Abschnitt (10) eines plattenförmigen Profilstranges mit T-Nuten (11) und zwei Eckteilen (20) zusammengesetzt ist,

   daß die Eckteile (20) als Abschnitte eines Eckprofilstranges ausgebildet und im Bereich der vertikalen Ränder auf der Außenseite des Abschnittes (10) befestigt sind, und

   daß die Eckteile (20) über die vertikalen Ränder des Abschnittes (10) vorstehen und in den vorstehenden Bereichen der parallel zur Innenseite des Abschnittes (10) verlaufenden Seiten die zur Außenseite hin versetzten T-Nuten (25) tragen.

3. Mehrzweck-Tischgehäuse nach Anspruch 2, dadurch gekennzeichnet,
daß der Eckprofilstrang als Kastenhohlprofil ausgebildet ist.

4. Mehrzweck-Tischgehäuse nach einem der Ansprüche 1 bis 3, dadurch gekennzeichnet,
daß auf der Außenseite der Abschnitte (10) im Bereich jedes vertikalen Randes jeweils mindestens eine Verbindungsnut (19) eingebracht ist,
daß die Eckteile (20) auf der dem Abschnitt (10) zugekehrten Seite mit Verbindungsstegen (21) versehen sind, die in zugeordnete Verbindungsnuten (19) des Abschnittes (10) eingeführt sind, und
daß im Bereich einander zugekehrter, senkrecht zum Abschnitt (10) stehender Seiten von Verbindungsnut (19) und Verbindungssteg (21) ein durchgehender, im Querschnitt runder und vertikal durchgehend verlaufender Verbindungskanal (22) für einen Verbindungsbolzen (23) ausgespart ist.

5. Mehrzweck-Tischgehäuse nach Anspruch 4, dadurch gekennzeichnet,
daß die Eckteile (20) mit einem Abschlußsteg (24) den zugekehrten vertikalen Rand des Abschnittes (10) abdecken.

6. Mehrzweck-Tischgehäuse nach einem der Ansprüche 1 bis 5, dadurch gekennzeichnet,
daß alle T-Nuten (11,25) gleichen Querschnitt aufweisen, wobei der hinterschnittene Bereich über zur Innenseite hin geneigte Übergangsabschnitte in den Einführungsschlitz der T-Nuten (11,25) übergeht.

7. Mehrzweck-Tischgehäuse nach einem der Ansprüche 1 bis 6, dadurch gekennzeichnet,
daß das Oberteil und das Unterteil (28) identisch ausgebildet und im Bereich der vertikalen Ränder der Seitenteile mit einem als Anschlag dienenden Absatz (29) versehen sind.

8. Mehrzweck-Tischgehäuse nach einem der Ansprüche 1 bis 7, dadurch gekennzeichnet,
daß der Durchmesser der Gewindebohrungen (18) in den Verbindungsleisten (17) größer ist als die Breite der Öffnung im Nutgrund (15) der T-Nuten (11,25).

9. Mehrzweck-Tischgehäuse nach einem der Ansprüche 1 bis 8, dadurch gekennzeichnet,
daß die Länge der Verbindungsleisten (17) und der Abdeckleisten (26) der Höhe des Abschnittes (10) und der Eckteile (20) der Seitenteile entspricht.

10. Mehrzweck-Tischgehäuse nach einem der Ansprüche 1 bis 9, dadurch gekennzeichnet,
daß der Abschnitt (10) und die beiden Eckteile (20) eines Seitenteils als einstückiger Abschnitt eines Seitenwand-Profilstranges zusammengefaßt sind.

11. Mehrzweck-Tischgehäuse nach einem der Ansprüche 1 bis 10, dadurch gekennzeichnet,
daß zum Einbau eines mit seitlichen Befestigungsflanschen (34) versehenen Baugruppenträgers (33) Befestigungswinkel (30) vorgesehen sind, die jeweils mit einem Schenkel über eine Verbindungsleiste (17) mit den Seitenteilen verschraubt sind, und
daß die Befestigungsflansche (34) des Baugruppenträgers (33) mit den gegeneinander gerichteten Schenkeln (32) der Befestigungswinkel (30) lösbar verbunden sind (Fig. 2).

12. Mehrzweck-Tischgehäuse nach einem der Ansprüche 1 bis 11, dadurch gekennzeichnet,
daß Leiterplatten-Tragschienen (40) über U-förmige Befestigungsteile (36) und Verbindungsleisten (17) mit den Seitenteilen verbunden sind (Fig. 3).

13. Mehrzweck-Tischgehäuse nach Anspruch 11 und 12, dadurch gekennzeichnet,
daß die Befestigungswinkel (30) und die Befestigungsteile (36) mit zusätzlichen Fixierstegen (31,39) versehen sind, die in T-Nuten (11) eingeführt den Befestigungswinkel (30) und das Befestigungsteil (36) bei einer Befestigung mittels einer einzigen Schraube (35) unverdrehbar am Seitenteil festhalten.

14. Mehrzweck-Tischgehäuse nach einem der Ansprüche 1 bis 13, dadurch gekennzeichnet,
daß eine boxartige Rückwand (42) mittels Vorreiber (47), die an der Rückwand (42) drehbar gelagert sind, durch einen Durchbruch (49) im vertikalen Rand (43) der Rückwand herausragen und in die nach außen versetzten T-Nuten (25) der Eckteile (20) einschwenkbar sind, an den Seitenteilen gehalten ist (Fig. 4).

15. Mehrzweck-Tischgehäuse nach einem der Ansprüche 1 bis 14, dadurch gekennzeichnet,
daß eine Tür oder ein Sichtfenster (55) im Bereich einer vertikalen Kante mit verschwenkbaren Scharnierteilen (53) von Scharnieren fest verbunden ist und
daß die damit gelenkig verbundenen feststehenden Scharnierteile (50) mittels Verbindungsleisten und Schrauben (52) in den nach außen versetzten T-Nuten (25) der Eckteile (20) festgelegt sind (Fig. 5).

16. Mehrzweck-Tischgehäuse nach Anspruch 15, dadurch gekennzeichnet, daß an den feststehenden Scharnierteilen (50) Verbindungsleisten mit Gewindebohrungen (51) angeformt sind.

17. Mehrzweck-Tischgehäuse nach einem der Ansprüche 1 bis 16, dadurch gekennzeichnet, daß die L-förmig ausgebildeten Einschub-Gleitschienen (56) mit einem Schenkel (57) mittels Verbindungsleisten (17) jeweils in mindestens zwei T-Nuten (11) eines Seitenteils horizontal gerichtet an den Seitenteilen befestigt sind (Fig. 6).

18. Mehrzweck-Tischgehäuse nach Anspruch 15, dadurch gekennzeichnet, daß Verschlußteile eines Verschlusses in derselben Weise mit der Tür oder dem Sichtfenster (55) sowie dem zugekehrten Eckteil (20) des Seitenteils verbunden sind.

19. Mehrzweck-Tischgehäuse nach einem der Ansprüche 1 bis 18, dadurch gekennzeichnet, daß ein Teil der T-Nuten (11) im Nutgrund (15) in im Querschnitt rechteckförmige Aufnahmekanäle (16) übergeht.

## Claims

1. Multi-purpose housing for electrotechnical equipment, which housing comprises two identical side-pieces, an upper portion and a lower portion and is provided with means for the installation of assembly carriers, printed circuit board supporting rails and push-in slide bars and for the attachment of a rear wall, a door or a viewing window, characterised in that the side-pieces have, on their inner surfaces, T-shaped grooves (11) which are disposed at identical spacings (T) from one another and extend continuously vertically, in that the groove base (15) is open in at least some of the T-shaped grooves (11), and extends into a continuous screw channel (14), which has a substantially circular cross-section, in that the first and last T-shaped grooves (25) in the side-pieces are disposed in corner members (20) and are offset from the associated inner surface by a prescribed distance in a direction towards the outer surface, and in that connection bars (17), having threaded bores (18) formed therein, or cover bars (26), are insertable into the T-shaped grooves (11, 25).

2. Multi-purpose housing according to claim 1, characterised in that each side-piece comprises a portion (10) of a plate-shaped extruded profile, having T-shaped grooves (11) formed therein, and two corner members (20), in that the corner members (20) are portions of an extruded corner profile and are mounted on the outer surface of the portion (10) in the region of the vertical edges, and in that the corner members (20) protrude beyond the vertical edges of the portion (10) and are provided with the T-shaped grooves (25), which are offset towards the outer surface, in the protruding regions of the surfaces extending parallel to the inner surface of the portion (10).

3. Multi-purpose housing according to claim 2, characterised in that the extruded corner profile is a box-shaped hollow profile.

4. Multi-purpose housing according to one of claims 1 to 3, characterised in that at least one connecting groove (19) is provided on the outer surface of the portions (10) in the region of each vertical edge, in that the corner members (20) are provided with connecting webs (21) on the surface facing the portion (10), which webs are introduced into associated connecting grooves (19) in the portion (10), and in that a continuous connecting channel (22), which has a circular cross-section and extends continuously vertically, for a connecting bolt (23) is formed in the region of surfaces of the connecting groove (19) and connecting web (21), which surfaces face one another and extend at right angles to the portion (10).

5. Multi-purpose housing according to claim 4, characterised in that the corner members (20), having an end web (24), cover the facing, vertical edge of the portion (10).

6. Multi-purpose housing according to one of claims 1 to 5, characterised in that all of the T-shaped grooves (11, 25) have identical cross-sections, the undercut region extending into the insert slot in the T-shaped grooves (11, 25) via transitional portions which are inclined towards the inner surface.

7. Multi-purpose housing according to one of claims 1 to 6, characterised in that the upper portion and the lower portion (28) are identical in form and are provided with a shoulder portion (29), which serves as a stop member, in the region of the vertical edges of the side-pieces.

8. Multi-purpose housing according to one of claims 1 to 7, characterised in that the diameter of the threaded bores (18) in the connection bars (17) is greater than the width of the opening in the groove base (15) of the T-shaped grooves (11, 25).

9. Multi-purpose housing according to one of claims 1 to 8, characterised in that the length of the connection bars (17) and of the cover bars (26) corresponds to the height of the portion (10) and the corner members (20) of the side-pieces.

10. Multi-purpose housing according to one of claims 1 to 9, characterised in that the portion (10) and the two corner members (20) of one side-piece are combined to form an integral portion of an extruded lateral wall profile.

11. Multi-purpose housing according to one of claims 1 to 10, characterised in that securing brackets (30) are provided for the installation of an assembly carrier (33), which is provided with lateral securing flanges (34), the securing brackets each being screw-connected to the side-pieces by a respective arm via a connection bar (17), and in that the securing flanges (34) of the assembly carrier (33) are detachably connected to the arms (32) of the securing brackets (30), which arms are orientated relative to one another (Fig. 2).

12. Multi-purpose housing according to one of claims 1 to 11, characterised in that printed circuit board supporting rails (40) are connected to the side-pieces through the intermediary of U-shaped securing members (36) and connection bars (17) (Fig. 3).

13. Multi-purpose housing according to claims 11 and 12, characterised in that the securing brackets (30) and the securing members (36) are provided with additional fixing webs (31, 39) which, when introduced into T-shaped grooves (11), retain the securing bracket (30) and the securing member (36) on the side-piece in a non-rotatable manner for securement by means of a single screw (35).

14. Multi-purpose housing according to one of claims 1 to 13, characterised in that a box-like rear wall (42) is retained on the side-pieces by means of fasteners (47), which are rotatably mounted on the rear wall (42), protrude through a bore (49) in the vertical edge (43) of the rear wall and are pivotable into the outwardly offset T-shaped grooves (25) in the corner members (20) (Fig. 4).

15. Multi-purpose housing according to one of claims 1 to 14, characterised in that a door or a viewing window (55) in the region of a vertical edge is securely connected to pivotable hinge members (53) by hinges, and in that the stationary hinge members (50), which are hence pivotally connected, are secured in the outwardly offset T-shaped grooves (25) in the corner members (20) by means of connection bars and screws (52).

16. Multi-purpose housing according to claim 15, characterised in that connection bars, having threaded bores (51) formed therein, are moulded to fit on the stationary hinge members (50).

17. Multi-purpose housing according to one of claims 1 to 16, characterised in that the L-shaped push-in slide bars (56), together with an arm (57), are secured on the side-pieces by means of connection bars (17) so that each is horizontally orientated in at least two T-shaped grooves (11) in a side-piece (Fig. 6).

18. Multi-purpose housing according to claim 15, characterised in that closure members of a closure are connected in the same manner to the door or the viewing window (55) as well as the facing corner member (20) of the side-piece.

19. Multi-purpose housing according to one of claims 1 to 18, characterised in that some of the T-shaped grooves (11) in the groove base (15) extend into receiver channels (16), which have a rectangular cross-section.

**Revendications**

1. Boîtier universel de pupitre pour des installations électrotechniques, boîtier qui se compose de deux pièces latérales semblables, d'une pièce supérieure et d'une pièce inférieure, et qui est muni de dispositifs destinés à l'incorporation de supports de modules, de barrettes de support de circuits imprimés et de rails coulissants rentrants, ainsi qu'à la mise en place d'une paroi arrière, d'une porte ou d'une fenêtre d'observation, boîtier caractérisé en ce que les pièces latérales présentent sur leurs côtés intérieurs des gorges (11) en T, qui s'étendent verticalement sans interruption et qui sont disposées avec des écarts (T) identiques entre elles ; en ce qu'au du moins dans une partie des gorges (11) en T, le fond (15) de la zone est ouvert et se transforme en un passage traversant (14) pour vis de section transversale approximativement ronde ; en ce que la première et la dernière gorge (25) en T des pièces latérales sont disposées dans des parties d'angle (20) et sont décalées, par rapport au côté intérieur correspondant, en direction du côté extérieur, dans une mesure déterminée à l'avance, et en ce que des barrettes (17) de liaison, comportant des trous taraudés (18), ou des barrettes (26) de recouvrement peuvent être enfilées dans les gorges (11, 25) en T.

2. Boîtier universel de pupitre selon la revendication 1, caractérisé en ce que chaque pièce latérale est composée d'un morceau (10) d'un profilé en forme de plaque comportant des gorges (11) en T et de deux pièces d'angle (20) ; en ce que les pièces d'angle (20) sont constituées par des morceaux d'un profilé d'angle et sont fixées, dans la zone des bords verticaux, sur le côté extérieur du morceau (10) de profilé ; et en ce que les pièces d'angle (20) font saillie au-delà des bords verticaux du morceau (10) de profilé et portent, dans les zones qui font saillie des côtés qui s'étendent parallèlement au côté intérieur du morceau (10) de ce profilé, les gorges (25) en T décalées en direction du côté extérieur.

3. Boîtier universel de pupitre selon la revendication 2, caractérisé en ce que le profilé d'angle a une forme de profilé creux à caisson.

4. Boîtier universel de pupitre selon l'une des revendications 1 à 3, caractérisé en ce que, sur le côté extérieur des morceaux (10) de profilé, au moins une gorge (19) de liaison est ménagée,dans chaque cas, dans la zone de chaque bord vertical ; en ce que les pièces d'angle (20) sont munies, sur le côté orienté vers le morceau (10) de profilé, de barrettes (21) de liaison,qui sont introduites dans des gorges(19)correspondantes de liaison ménagées dans le morceau (10) de profilé ; et en ce que, dans la zone des côtés de la gorge (19) de liaison et de la barrette (21) de liaison, dirigés l'un vers l'autre et qui sont perpendiculaires au morceau (10) de profilé, un canal (22) de liaison, de section transversale ronde et s'étendant verticalement de bout en bout,est ménagé pour recevoir une tige (23) de liaison.

5. Boîtier universel de pupitre selon la revendication 4, caractérisé en ce que les pièces d'angle (20) recouvrent au moyen d'une barrette (24) de finition le bord vertical, dirigé vers celle-ci, du morceau (10) de profilé.

6. Boîtier universel de pupitre selon une des revendications 1 à 5, caractérisé en ce que toutes les gorges (11, 25) en T présentent la même section transversale, la zone en retrait se transformant, par l'intermédiaire de parties de transition inclinées en direction du côté intérieur, en la fente d'introduction dans les gorges (11, 25) en T.

7. Boîtier universel de pupitre selon une des revendications 1 à 6, caractérisé en ce que la pièce supérieure et la pièce inférieure (28) ont une conformation identique et sont munies, dans la zone des bords verticaux des pièces latérales, d'un talon (29) servant de butée.

8. Boîtier universel de pupitre selon une des revendications 1 à 7, caractérisé en ce que le diamètre des trous (18) taraudés des barrettes (17) de liaison est supérieur à la largeur de l'ouverture du fond (15) des gorges (11, 25) en T.

9. Boîtier universel de pupitre selon une des revendications 1 à 8, caractérisé en ce que la longueur des barrettes (17) de liaison et des barrettes (26) de recouvrement correspond à la hauteur du morceau (10) de profilé et des pièces d'angle (20) des pièces latérales.

10. Boîtier universel de pupitre selon une des revendications 1 à 9, caractérisé en ce que le morceau (10) de profilé et les deux pièces d'angle (20) d'une pièce latérale sont rassemblés en un morceau, constituant une seule pièce, d'un profilé de paroi latérale.

11. Boîtier universel de pupitre selon une des revendications 1 à 10, caractérisé en ce qu'en vue du montage d'un support (33) de modules, muni de pattes (34) latérales de fixation, on prévoit des équerres (30) de fixation qui sont chacune vissées par une branche par l'intermédiaire d'une barrette (17) de liaison, aux pièces latérales, et en ce que les pattes (34) de fixation du support (33) de modules sont reliées, de façon démontable, aux branches (32) dirigées les unes vers les autres, des équerres (30) de fixation (figure 2).

12. Boîtier universel de pupitre selon une des revendications 1 à 11, caractérisé en ce que des glissières (40) de support de circuits imprimés sont reliées aux pièces latérales par l'intermédiaire de pièces (36) de fixation en forme de U et de barrettes (17) de liaison (figure 3).

13. Boîtier universel de pupitre selon une des revendications 11 et 12, caractérisé en ce que les équerres (30) de fixation et les pièces (36) de fixation sont munies de barrettes (31, 39) supplémentaires de fixation qui, étant introduites dans les gorges (11) en T, fixent sur la pièce latérale l'équerre (30) de fixation et la pièce (36) de fixation de façon à les empêcher de tourner, la fixation étant assurée au moyen d'une seule vis.

14. Boîtier universel de pupitre selon une des revendications 1 à 13, caractérisé en ce qu'une paroi arrière (42), en forme de boîte, est maintenue sur les pièces latérales au moyen de pattes tournantes (47) qui sont montées de façon rotative sur la paroi arrière (42) et qui dépassent par un passage (49) ménagé dans le bord vertical (43) de la paroi arrière et peuvent être amenées par pivotement dans les gorges (25) en T, décalées vers l'extérieur, des pièces d'angle (20) (figure 4).

15. Boîtier universel de pupitre selon une des revendications 1 à 14, caractérisé en ce qu une porte ou une fenêtre (55) d'observation est fixée dans la zone d'un bord vertical, au moyen de pièces ou parties (53) pivotantes de charnières ; et en ce que les pièces fixes (50) de charnière, qui leur sont ainsi reliées de façon articulée, sont fixées au moyen de barrettes de fixation et de vis (52) dans les gorges (25) en T, décalées vers l'extérieur, des pièces d'angle (20) (figure 5).

16. Boîtier universel de pupitre selon la revendication 15, caractérisé en ce que, sur les pièces (50) fixes de charnière sont formées des barrettes de liaison comportant des trous taraudés (51).

17. Boîtier universel de pupitre selon une des revendications 1 à 16, caractérisé en ce que les rails coulissants rentrants (56), en forme de L, sont fixés horizontalement sur les pièces latérales par une branche (57), au moyen de barrettes (17) de liaison, chacune dans au moins deux gorges (11) en T d'une pièce latérale (figure 6).

18. Boîtier universel de pupitre selon la revendication 15, caractérisé en ce que les pièces de fermeture d'un dispositif de fermeture sont reliés de la même manière à la porte ou à la fenêtre (55) d'observation ainsi qu'à la pièce d'angle (20) orientée vers elles, de la pièce latérale.

19. Boîtier universel de pupitre selon l'une des revendications 1 à 18, caractérisé en ce qu'une partie des gorges (11) en T se transforme au fond (15) de la gorge en des canaux récepteurs (16) ayant en section transversale une forme rectangulaire.

FIG.1

FIG. 2

FIG.3

FIG.4

FIG.5

FIG.6